# EUROPEAN PATENT APPLICATION

(11) **EP 1 239 559 A2**
(43) Date of publication of application: **11.09.2002**
(21) Application number: 02005057.1
(22) Date of filing: 06.03.2002
(51) Int. Cl.: H01S 5/022, G02B 6/42

(54) **Semiconductor laser module and method for optically coupling laser light and optical fiber**

(30) Priority: 06.03.2001 JP 2001062049
(71) Applicant: The Furukawa Electric Co., Ltd., Tokyo 100-8322 (JP)
(72) Inventor: Miyokawa, Jun, Chiyoda-ku, Tokyo 100-8322 (JP)
(74) Representative: Sajda, Wolf E., Dipl.-Phys.

(57) **Abstract**

A semiconductor laser module comprising a semiconductor laser (1) for emitting light; an optical fiber (4) having a tip end side opposing to the semiconductor laser (1), which tip end side is formed into a lens shape (14) so as to optically couple with the semiconductor laser (1); an optical-fiber supporting member (3) for supporting the optical fiber (4); and at least one fixing member (6) including: a supporting-member fitting portion (17) having a groove portion or a hole portion (25) for fittedly and insertedly receiving the optical-fiber supporting member (3); fixing block portions (18) positioned at both sides of the supporting-member fitting portion (17), respectively, so as to interpose the supporting-member fitting portion (3) between the fixing block portions (18) via gaps in a direction intersecting the longitudinal direction of the optical fiber (4); and bridge portions (16) for coupling the fixing block portions (18) to the supporting-member fitting portion (17), respectively, so as to support the optical-fiber supporting member (3).

## Description

### Field of the Invention

The present invention relates to a semiconductor laser module and a method for optically coupling a laser light and an optical fiber, to be used in an optical communications industry.

### Related Art

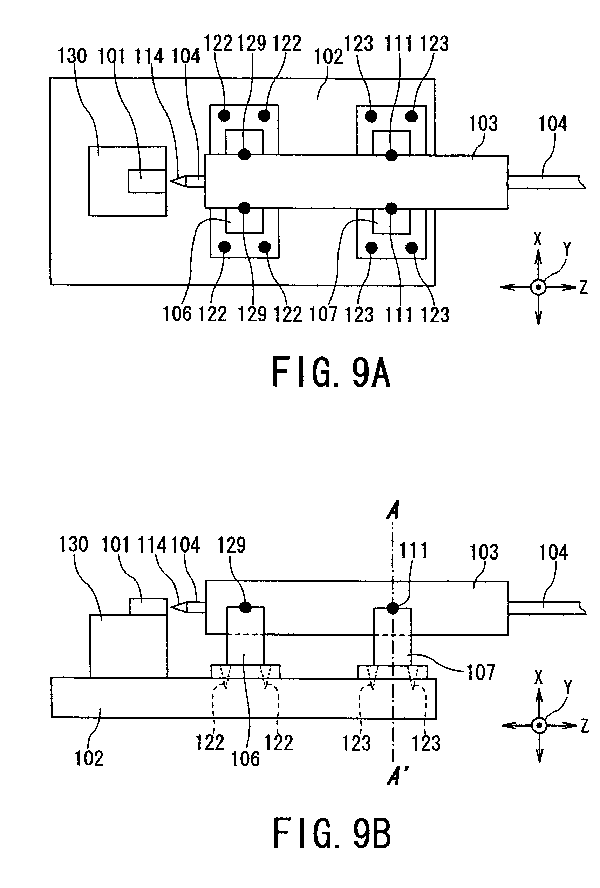

Semiconductor laser modules are fabricated into module forms by optically coupling semiconductor lasers (optical semiconductor devices) for emitting light to optical fibers for propagating the light therefrom. FIG. 9A is a plan drawing of an example of a conventional semiconductor laser module, and FIG. 9B is a side drawing of the semiconductor laser module.

The semiconductor laser module shown in FIGS. 9A and 9B includes, for example, a base 102 made of metal. Provided at the upper side of the base 102 is a device supporting pedestal 130 on which a semiconductor laser 101 is fixedly provided. Provided opposingly to the semiconductor laser 101 with a gap is an optical fiber 104. The tip end portion of the optical fiber 104 facing to the semiconductor laser is formed into lens-shaped configuration for a lens portion 114. The base 102 and device supporting pedestal 130 may be integrally formed as a unit.

As shown in FIGS. 9A and 9B, the optical fiber 104 penetrates through a ferrule 103 acting as an optical-fiber supporting member, and is fixed therein. The lens portion 114 at the tip end portion of the optical fiber 104 is protruded from the ferrule 103. The ferrule 103 is made of metal, and arranged in a state where the lens portion 114 of the optical fiber 104 is directed toward the semiconductor laser 101.

Provided at each side of the ferrule 103 are clamping/fixing members 106, 107 made of metal, in a separated manner in the longitudinal direction of the optical fiber 104 via a gap, such that these clamping/fixing members 106, 107 clampingly fix the ferrule 103. The clamping/fixing member 106, which supports the ferrule 103 at a position closer to the semiconductor laser 101, is fixed with the ferrule 103 at clamping/fixing portions 129 by YAG welding, or the like.

The clamping/fixing member 107, which supportingly fixes the ferrule 103 at a position distal to the semiconductor laser 101, fixes the ferrule 103 at clamping/fixing portions 111 by YAG welding or the like. The clamping/fixing members 106, 107 are fixed to the base 102 at fixing portions 122, 123, respectively, by YAG welding or the like.

As described above, the optical fiber 104 is fixed to the base 102 through the ferrule 103 by the clamping/fixing members 106, 107, in a state where the center core of the optical fiber 104 is optically coupled to the center of the laser light of the semiconductor laser 101 (i.e., the optical fiber 104 and semiconductor laser 101 are aligned).

Although not shown in FIG. 9, the semiconductor laser module is formed so as to accommodate the components shown in FIG. 9 in a package, and the optical fiber 104 is drawn out of a through-hole formed in a side wall of the package, to the exterior of the package.

In the aforementioned semiconductor laser module, when the semiconductor laser 101 has an elliptical light emitting pattern, for example, it is typical that the tip end portion of the lens portion 114 is worked into an appropriate shape such as wedge shape, hemispherical shape or truncated conical shape, so as to facilitate the optical coupling of the tip end portion of the lens portion 114 to the semiconductor laser 101, to thereby obtain a higher optical coupling efficiency. Such an alignment of the optical fiber 104 with the semiconductor laser 101 is allowed to obtain a higher optical coupling efficiency as compared with alignment of an optical fiber with the semiconductor laser 101 in such a constitution that the optical fiber formed with no lens portions 114 at its tip end portion is arranged so as to face to the semiconductor laser 101 while providing an optical lens such as a spherical lens or aspherical lens between the semiconductor laser 101 and the optical fiber. However, it is also typical that the tolerance of the optical coupling is extremely narrow for the alignment of the shown optical fiber 104 with the semiconductor laser 101, thereby requiring a higher precision for the optical coupling (i.e., for the alignment).

More specifically, the reason for requiring the alignment between the optical fiber 104 and semiconductor laser 101 lies in that the optical coupling tolerance for a positional deviation of the optical fiber 104 is extremely narrow compared with the above-mentioned case, thus making it essential to conduct the alignment at an extremely higher precision and then fix the optical fiber 104.

Thus, there has been applied such a method as follows, in fabricating the semiconductor laser module shown in FIGS. 9A, 9B. More specifically, the semiconductor laser 101 is firstly provided on and fixed to the device supporting pedestal 130. Then, the tip end side of the ferrule 103 is provided on the first clamping/fixing member 106, and weldedly fixed thereto at positions of clamping/fixing portions 129 by YAG laser or the like.

At this time, there is conducted positional registration for causing: the height position of the optical axis of the semiconductor laser 101 relative to the base 102 to substantially be in agreement with the height position of the optical axis of the optical fiber 104 relative to the base 102 (i.e., for causing the optical axis of the semiconductor laser 101 to substantially be in agreement with the optical axis of the optical fiber 104 in the Y-axis direction). Then, the first clamping/fixing member 106 is moved in the X-axis direction and Z-axis direction in FIGS. 9A and 9B. In this way, the emitting position of the semiconductor laser 101 is positionally registered with the optical axis of the optical fiber 104 in the X-axis direction, and the semiconductor laser 101 and optical fiber 104 are positionally registered with each other in the X-axis direction so that the laser light of the semiconductor laser 101 is received by the optical fiber 104.

After positionally registering the semiconductor laser 101 and optical fiber 104 with each other in the X-axis, Y-axis and Z-axis directions, the first clamping/fixing member 106 is fixed to the base 102 at the fixing portions 122 by YAG welding, taking account of the positional relationship relative to the ferrule 103. Thereafter, the ferrule 103 is weldedly fixed to the first clamping/fixing member 106.

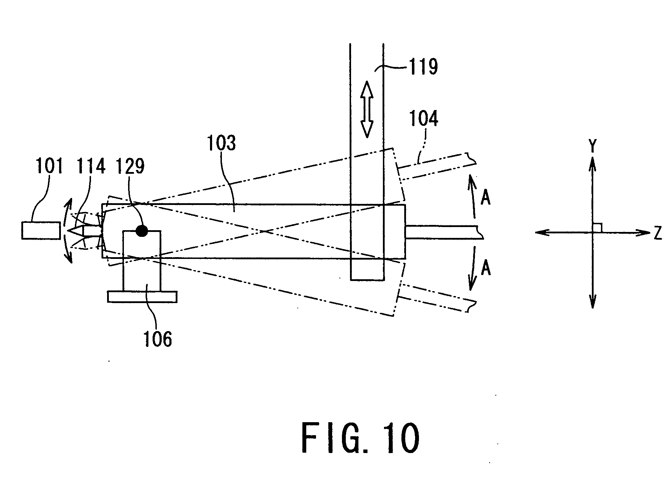

Next, the rear end side of the ferrule 103 is tilted in an arrow A direction of FIG. 10 by an aligning jig 119, about the clamping/fixing portions 129 acting as a fulcrum. This finely moves the tip end side of the lens portion 114 of the optical fiber 104 in the Y-axis direction in FIG. 10, to thereby positionally register the optical axis of the optical fiber 104 with the optical axis of the semiconductor laser 101 in the Y-axis direction by such a fine adjustment.

Under this state, the second clamping/fixing member 107 is fixed to the base 102 at the fixing portions 123 by YAG welding, and the rear end side of the ferrule 103 is weldedly fixed to the second clamping/fixing member 107 at the clamping/fixing portions 111, as shown in FIGS. 9A and 9B.

However, upon conducting the alignment of the optical fiber 104 with the semiconductor laser 101 in the aforementioned semiconductor laser module, the side of the ferrule 103 which is near to the semiconductor laser 101 is fixed by YAG-laser welding to the first clamping/fixing member 106 at the clamping/fixing portions 129, and the ferrule 103 is tilted about the welding portions acting as the fulcrum. This applies excessive torsional forces to the welding portions upon the angular swing, thereby causing a possibility of cracks or breakage at the welding portions, upon the angular swing or during usage of the semiconductor laser module thereafter. This has caused a problem of inferior reliability of the semiconductor laser module, such as a lowered output at the optical fiber end.

### Summary of the invention

There is provided one embodiment of a semiconductor laser module of the present invention which comprises:
a semiconductor laser for emitting light;
an optical fiber having a tip end side opposing to the semiconductor laser, which tip end side is formed into a lens shape so as to optically couple with the semiconductor laser;
an optical-fiber supporting member for supporting the optical fiber; and
at least one fixing member including: a supporting-member fitting portion having a groove portion or hole portion into which the optical-fiber supporting member is inserted and fitted; fixing block portions positioned at both sides of the supporting-member fitting portion, respectively, so as to interpose the supporting-member fitting portion between the fixing block portions via gaps in a direction intersecting the longitudinal direction of the optical fiber; and bridge portions for coupling the fixing block portions to the supporting-member fitting portion, respectively; so as to support the optical-fiber supporting member.

There is provided one embodiment of an optical coupling method of a semiconductor laser module of the invention, which comprises the steps of:
preparing said first fixing member, said second fixing member, said semiconductor laser, said optical fiber, said optical-fiber supporting member and said base as recited in any one of claims 1 to 6;
performing a first step of optical coupling between said semiconductor laser and said optical fiber in a state where said optical-fiber supporting member is inserted and fitted by said supporting-member fitting portion of said first fixing member, to fix said fixing block of said fixing member to said base;
then, performing a second step of optical coupling between said semiconductor laser and said optical fiber in a state where said fixing block portion is fixed to said base, to fix said optical-fiber supporting member to said supporting-member fitting portion of said first fixing member;
performing a third step of optical coupling by means of moving a far end side of said optical-fiber supporting member from said semiconductor laser about a fulcrum consisting of said bridge portions of said first fixing member in a state where said optical-fiber supporting member is fixed to said supporting-member fitting portion, to fix said second fixing member to said base; and
then, performing a fourth step of optical coupling between said semiconductor laser and said optical fiber by means of further moving said far end side of said optical-fiber supporting member from said semiconductor laser, to fix said optical-fiber supporting member to said second fixing member.

There is provided one embodiment of a fixing member for supporting an optical-fiber supporting member of a semiconductor laser module of the invention, which comprises:
a supporting-member fitting portion having a groove portion or hole portion into which the optical-fiber supporting member for supporting an optical fiber is inserted and fitted;
fixing block portions positioned at both sides of the supporting-member fitting portion, respectively; and
column-like bridge portions for coupling the supporting-member fitting portion to the fixing block portions, respectively.

### Brief description of the drawings

FIG. 1 is a drawing to show a fixing member of the present invention;
FIG. 2 is a schematic drawing of a semiconductor laser module according to an embodiment of the present invention;
FIG. 3 is a plan drawing of the semiconductor laser module of FIG. 2;
FIG. 4 is a cross-sectional drawing of the semiconductor laser module of the embodiment;
FIG. 5 is a front drawing of a fixing member according to another embodiment of the present invention;
FIG. 6 is a schematic drawing showing an embodiment of an optical coupling method of a semiconductor laser module;
FIG. 7 is a partial schematic drawing of a semiconductor laser module according to another embodiment of the present invention;
FIG. 8 is a partial schematic drawing of a semiconductor laser module according to further another embodiment of the present invention;
FIG. 9 is a schematic drawing showing an example of a conventional semiconductor laser module; and
FIG. 10 is a schematic drawing showing an optical coupling method in the conventional semiconductor laser module.

### Detailed description of the invention

There will be described hereinafter embodiments of semiconductor laser modules, fixing members and optical coupling method of semiconductor laser module of the present invention, with reference to the accompanying drawings. It is an object of the present invention to provide a semiconductor laser module, which prevents cracks at supporting pints such as YAG welding portions of an optical-fiber supporting member or the like upon fabricating or during usage of the semiconductor laser module, having an excellent optical coupling efficiency between the semiconductor laser and optical fiber as well as a long-term reliability.

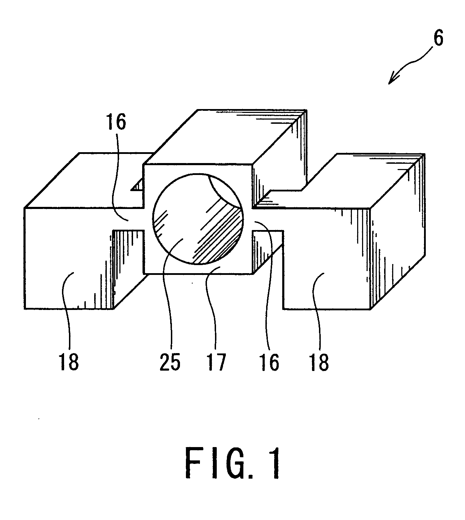

FIG. 1 is a schematic drawing to show a fixing member of the present invention.

The fixing member of the present invention has one configuration comprising: a supporting-member fitting portion having a groove portion or hole portion into which the optical-fiber supporting member (hereinafter equally called "ferrule") to support an optical fiber is inserted or placed so as to be fitted therein; fixing block portions positioned at both sides of the supporting-member fitting portion, respectively; and column-shaped bridge portions for connecting the fixing block portions to the supporting-member fitting portion, respectively, so as to support the ferrule of the semiconductor laser module. In the fixing member of the present invention, the fixing block portions, supporting-member fitting portion and bridge portions for connecting them are integrally formed as a single member to thereby cause the bridge portions to share torsional stress applied thereto.

Further, in the fixing member of the present invention, the supporting-member fitting portion may comprises a rectangular block, each bridge portion may comprises a rectangular column, polygonal column or round column, each bridge portion has its sectional area smaller than that of the hole portion of the supporting-member fitting portion, and the supporting-member fitting portion, fixing block portions and bridge portions are integrally formed as a single member. As shown in Fig. 1, the end surface of each bridge portion, which is proximal to the semiconductor laser, may be flush with that end surface of the supporting-member fitting portion, which is proximal to the semiconductor laser. In addition, each bridge portion may be provided at the substantially same height as the center core of the optical fiber.

More specifically, as shown in FIG. 1, the fixing member 6 of the present invention for supporting a ferrule of a semiconductor laser module, comprises: a supporting-member fitting portion 17 having a hole portion 25, for supporting the optical fiber (not shown); fixing block portions 18 positioned at the both sides of the supporting-member fitting portion 17, respectively; and column-shaped bridge portions 16 for connecting the fixing block portions 18 to the supporting-member fitting portion 17, respectively.

Furthermore, the hole portion of the supporting-member fitting portion may be configured in such manner that the end portion thereof to which the ferrule is inserted is made wider, or the hole portion is tapered as a whole so as for the ferrule to be easily inserted.

As shown in FIG. 1, the fixing block portions 18, supporting-member fitting portion 17 and bridge portions 16 for connecting the above-mentioned two portions are integrally formed as a single member, to thereby cause the bridge portions 16 to share the torsional stresses applied through the optical-fiber supporting member to the fixing member upon aligning of the optical axis. Further, the sectional area of each bridge portion 16 is smaller than that of the hole portion 25 of the supporting-member fitting portion 17. As described above, the bridge portions 16 comprise rectangular columns, polygonal columns or round columns, and the bridge portions together with the fixing block portions 18 and supporting-member fitting portion 17 share those stresses applied or loaded to the fixing member, which is caused by the slight movements of the ferrule in the X, Y, Z directions and slight movements in the rotating direction of the optical-fiber supporting member, for optical coupling.

There will be described hereinafter the semiconductor laser module of the present invention.

The semiconductor laser module of the present invention comprises, in its one configuration:
a semiconductor laser for emitting light;
an optical fiber having a tip end portion opposing to said semiconductor laser, which tip end portion is formed into a lens-shaped configuration so as to optically couple with said semiconductor laser;
an optical-fiber supporting member for supporting said optical fiber; and
at least one fixing member for supporting said optical-fiber supporting member, including: a supporting-member fitting portion having a groove portion or hole portion into which said optical-fiber supporting member is inserted or placed so as to be fitted therein; fixing block portions positioned at opposite sides of said supporting-member fitting portion, respectively, so as to interpose said supporting-member fitting portion between said fixing block portions via gaps in a direction intersecting a longitudinal direction of said optical fiber; and bridge portions for coupling said fixing block portions to said supporting-member fitting portion, respectively.

Furthermore, the semiconductor laser module of the present invention comprises, in its one configuration:
a semiconductor laser for emitting light;
an optical fiber having a tip end portion opposing to said semiconductor laser, which tip end portion is formed into a lens-shaped configuration so as to optically couple with said semiconductor laser;
an optical-fiber supporting member for supporting said optical fiber; and
a group of fixing members comprising:
   (i) a first fixing member for supporting said optical-fiber supporting member, including: a supporting-member fitting portion having a groove portion or hole portion into which said optical-fiber supporting member is inserted or placed so as to be fitted therein; fixing block portions positioned at opposite sides of said supporting-member fitting portion, respectively, so as to interpose said supporting-member fitting portion between said fixing block portions via gaps in a direction intersecting a longitudinal direction of said optical fiber; and bridge portions for coupling said fixing block portions to said supporting-member fitting portion, respectively; and
   (ii) at least one additional fixing member for supporting said optical-fiber supporting member, arranged at a distance from said first fixing member, along the longitudinal direction of said optical fiber.

In the semiconductor laser module of the present invention, the aforementioned group of fixing members comprise the first fixing member and at least one second fixing member. Further, the supporting-member fitting portion has a hole portion into which said optical-fiber supporting member is inserted so as to be fitted therein. Moreover, as described above, the fixing block portions, the supporting-member fitting portion and the bridge portions for connecting them are integrally formed as a single member, to thereby cause the bridge portions to share the torsional stress applied thereto. Each of the fixing block portions may be extended to a periphery of the second fixing member. Further, as described above, each bridge portion may be arranged at a substantially same height as the optical axis of the semiconductor laser. Moreover, as described above, the end surface of each bridge portion which is proximal to the semiconductor laser may be flush with the end surface of the supporting-member fitting portion which is proximal to the semiconductor laser.

Further, the semiconductor laser module of the present invention further comprises a base including a semiconductor-laser mounting member and a fixing-member mounting member (i.e., a member having portions in which at least one fixing-member is received and fixed) provided on the semiconductor-laser mounting member. The fixing-member mounting member may have recessed portions corresponding to the fixing block portions, so as to fix the fixing block portions by the recessed portions.

Further, the fixing-member mounting member of the base has an upper surface arranged at a substantially same height as the center of the laser light of the semiconductor laser. Moreover, joining portions between the fixing block portions of the first fixing member and the fixing-member mounting member of the base are arranged at a substantially same height as the center of the laser light of the semiconductor laser. Furthermore, joining portions of the second fixing member to the fixing-member mounting member of the base and joining portions of the second fixing member to the optical-fiber supporting member are arranged at the substantially same heights as the center of the laser light of the semiconductor laser. In general, ferrules are formed of Fe-Ni-Co (Trademark: "KOVAR") having a coefficient of thermal expansion similar to that of optical fibers. Thus, it is preferable that the fixing members to be fixed by laser-welding to the ferrule are formed of the same metal or metals having similar thermal expansion coefficients as the ferrules, in view of a laser weldability. It is also possible to adopt a metal such as Ni having a smaller Young's modulus, taking account of the torsionability of the bridge portions. For example, the first fixing member is formed by cutting a Fe-Ni alloy, Fe-Ni-Co alloy, or metal such as nickel having a smaller Young's modulus. The aforementioned joining portions comprise laser-welded portions.

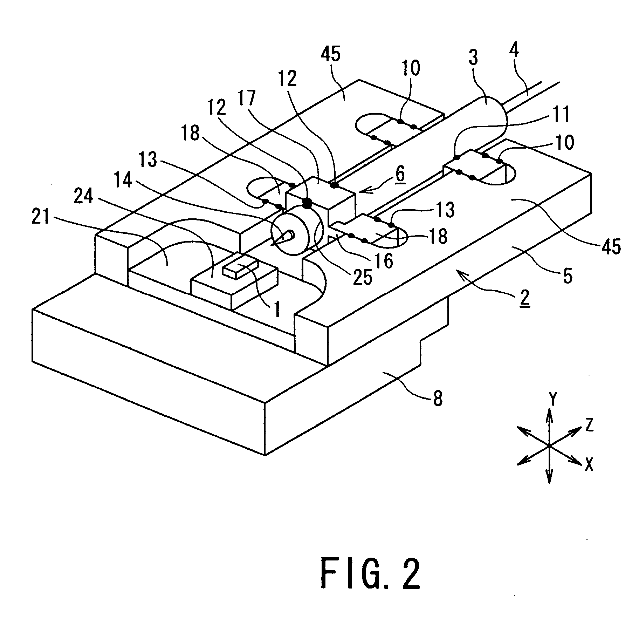

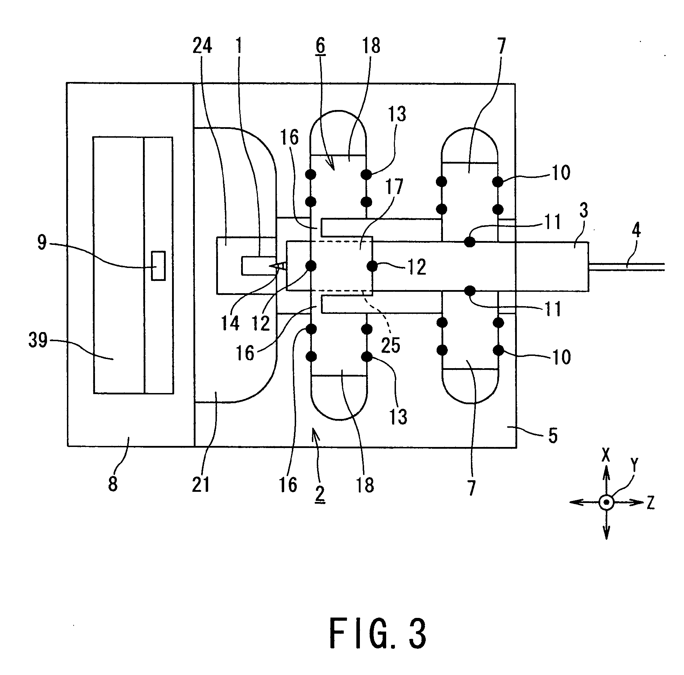

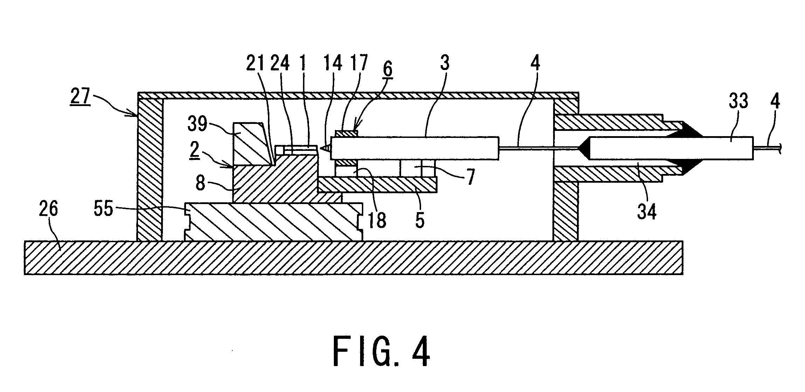

FIG. 2 is a partial explanatory drawing of a semiconductor laser module according to an embodiment of the present invention. FIG. 2 omits a package of the semiconductor laser module. FIG. 3 is a plan drawing of the semiconductor laser module of FIG. 2. FIG. 4 is a cross-sectional drawing of the semiconductor laser module of the above embodiment.

As shown in FIGS. 2, 3, the semiconductor laser module of this embodiment includes a semiconductor laser 1, an optical fiber 4 arranged so as to face to the semiconductor laser 1, a ferrule 3 for supporting the optical fiber 4, and a base 2 for fixing the ferrule 3, such that the ferrule 3 is fixed to the base 2 through first fixing member 6 and second fixing member 7. The semiconductor laser module of the embodiment is characterized by a distinctive constitution of the first fixing member 6 and base 2, as well as by a distinctive fixing structure of the ferrule 3 to the base 2.

More specifically, as described above and as shown in FIGS. 1 to 3, the first fixing member 6 in this embodiment includes: the supporting-member fitting portion 17 having the hole portion 25 into which the ferrule 3 is inserted to be fitted; the fixing block portions 18 positioned at opposite sides of the supporting-member fitting portion 17, respectively, so as to interpose the supporting-member fitting portion 17 between the fixing block portions 18 through gaps in a direction intersecting the longitudinal direction of the optical fiber 4; and bridge portions 16 for connecting the fixing block portions 18 to the supporting-member fitting portion 17.

The bridge portions 16 may be formed at positions substantially in agreement with the center of the laser light of the semiconductor laser 1 and the center core of the optical fiber 4. The end surface of each bridge portion 16 which is near to the semiconductor laser 1 may be in agreement with the end surface of the supporting-member fitting portion 17 which is near to the semiconductor laser 1. As described above, the first fixing member is formed by cutting a Fe-Ni alloy, Fe-Ni-Co alloy, or metal such as nickel having a smaller Young's modulus.

The supporting-member fitting portion 17 of the first fixing member 6 and the ferrule 3 are fixed by laser welding or soldering at fixing portions such as YAG-welding portions 12. Further, in this embodiment, the base 2 has a semiconductor-laser mounting member 8 and a fixing-member mounting member 5, and the fixing block portions 18 of the first fixing member 6 and the fixing-member mounting member 5 of the base 2 are fixed at YAG-welding portions 13. The fixing-member mounting member 5 of the base 2 has an upper surface 45 formed at a substantially same height as the center of the laser light of the semiconductor laser 1. Thus, the height of the YAG-welding portions 13 is substantially the same as the height of the center of the laser light of the semiconductor laser 1.

In other embodiment of the invention, the base 2 and the semiconductor-laser mounting member 8 may be integrally formed as a single member.

In this embodiment, YAG-welding portions 10 at which the second fixing member 7 is fixed to the base 2, and clamping/fixing portions (YAG-welding portions) 11 at which the second fixing member 7 is fixed to the ferrule 3 are also formed at the substantially same height as the center of the laser light of the semiconductor laser 1.

The semiconductor-laser mounting member 8 is provided, for example, at the lower side of the fixing-member mounting member 5 (alternatively, may be provided on the same plane). As shown in FIG. 4, the semiconductor-laser mounting member 8 is fixed by soldering, resin or adhesive agent or the like onto a bottom plate 26 of a package 27 through thermo-module 55. Depending on specifications, the thermo-module 55 may be omitted such that the semiconductor-laser mounting member 8 is provided and fixed by soldering, resin or adhesive agent or the like onto the bottom plate 26 of the package 27, directly or through thermal conductive member or the like.

The semiconductor-laser mounting member 8 is provided with, at its upper side, an LD bonding portion 21 constituted of a member integral with the semiconductor-laser mounting member 8. The semiconductor laser 1 is fixed on the LD bonding portion 21, directly, or via heat sink 24 taking account of heat dissipation of the LD.

Further, as shown in FIG. 3, there is provided a PD (photodiode) carrier 39 (not shown in FIG. 2) at a position avoiding the LD bonding portion 21 of the semiconductor-laser mounting member 8, and the PD carrier 39 is provided with a photodiode 9 (not shown in FIG. 2) for monitoring the output of the semiconductor laser 1. The fixing-member mounting member 5 is also arranged at a position avoiding the LD bonding portion 21 of the semiconductor-laser mounting member 8.

Also in this embodiment, a lens portion 14 is formed in the tip end portion of the optical fiber 4 which faces to the semiconductor laser 1. Further, as shown in FIG. 4, provided at a midway portion of the optical fiber 4 is a ferrule 33 which is fixed to a through-hole forming portion 34 of the package 27 by soldering, adhesive, resin or a combination thereof, while the optical fiber 4 is drawn out to the exterior from the package 27 of the semiconductor laser module.

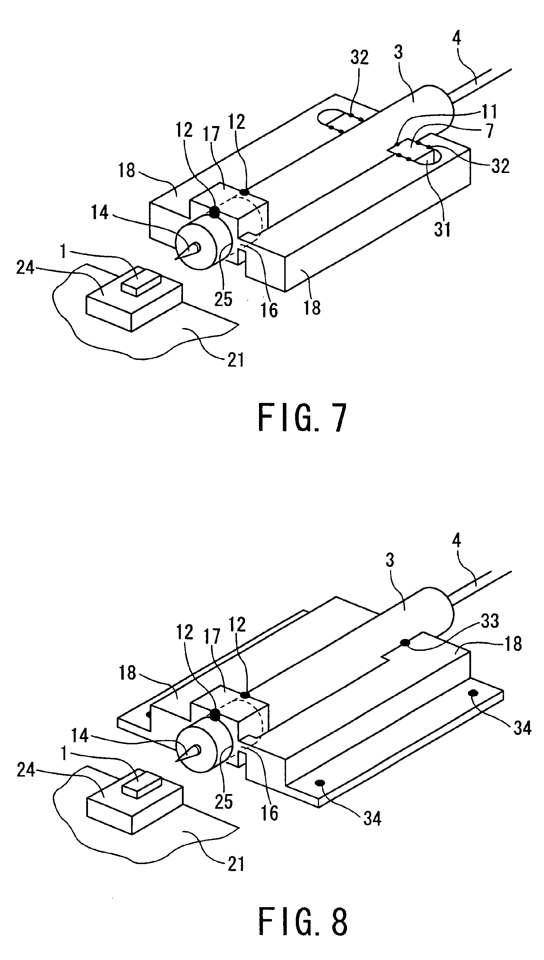

FIG. 7 is a partial explanatory drawing of a semiconductor laser module according to another embodiment of the present invention. In this embodiment, the fixing block portions 18 are extended up to the peripheral portions of the second fixing member 7 as shown in FIG. 7, and each fixing block portion 18 is provided with another concave portion 31 at a position corresponding to the second fixing member 7. The second fixing member 7 and ferrule 3 are fixed at clamping/fixing portions 11 by YAG welding or the like. The second fixing member 7 and each concave portion 31 of the fixing block portions 18 are mutually fixed at YAG-welding portions 32. Although not shown, the fixing block portions 18 are fixed to the fixing-member mounting member 5 of the base 2 by YAG-welding portions, similarly to the configuration shown in FIG. 2.

FIG. 8 is a partial explanatory drawing of a semiconductor laser module according to other embodiment of the present invention. In this embodiment, the first fixing member and second fixing member are integrally formed as a single member, as shown in FIG. 8. More specifically, the fixing block portions 18 of the first fixing member are extended along the axial direction of the ferrule 3, such that those end portions of fixing block portions 18 distal to the semiconductor laser 1 act as the second fixing member and are fixed to the ferrule 3 at YAG-welding portions. The fixing block portions 18 and the fixing-member mounting member 5 of the base 2 are mutually fixed at YAG-welding portions 34.

There will be described hereinafter an aligning method of a semiconductor laser module according to the present invention.

One embodiment of an aligning method of a semiconductor laser module of the invention comprises the steps of:
preparing said first fixing member, said second fixing member, said semiconductor laser, said optical fiber, said optical-fiber supporting member and said base as recited in the above;
performing a first step of optical coupling between said semiconductor laser and said optical fiber in a state where said optical-fiber supporting member is inserted and fitted received by said supporting-member fitting portion of said first fixing member, to fix said fixing block of said fixing member to said base;
then, performing a second step of optical coupling between said semiconductor laser and said optical fiber in a state where said fixing block portion is fixed to said base, to fix said optical-fiber supporting member to said supporting-member fitting portion of said first fixing member;
performing a third step of optical coupling by means of moving a far end side of said optical-fiber supporting member from said semiconductor laser about a fulcrum consisting of said bridge portions of said first fixing member in a state where said optical-fiber supporting member is fixed to said supporting-member fitting portion, to fix said second fixing member to said base; and
then, performing a fourth step of optical coupling between said semiconductor laser and said optical fiber by means of further moving said far end side of said optical-fiber supporting member from said semiconductor laser, to fix said optical-fiber supporting member to said second fixing member.

During the first optical coupling stage, there is conducted the alignment for the ferrule in three directions consisting of an X-axis direction (widthwise direction of the semiconductor laser module), a Y-axis direction (vertical direction) and a Z-axis direction (longitudinal direction of the semiconductor laser module). More specifically, the optical coupling is conducted in each of the X-axis direction (widthwise direction of the semiconductor laser module), the Y-axis direction (vertical direction) and the Z-axis direction (longitudinal direction of the semiconductor laser module).

During the second optical coupling stage, there is conducted the alignment for the ferrule in the Z-axis direction (longitudinal direction of the semiconductor laser module) and Y-axis direction (vertical direction), respectively.

During the third optical coupling stage, there is conducted alignment for the ferrule in the X-axis direction (widthwise direction of the semiconductor laser module).

During the fourth optical coupling stage, there is conducted alignment for the ferrule in the Y-axis direction (vertical direction).

There will be described hereinafter a concrete optical coupling method.

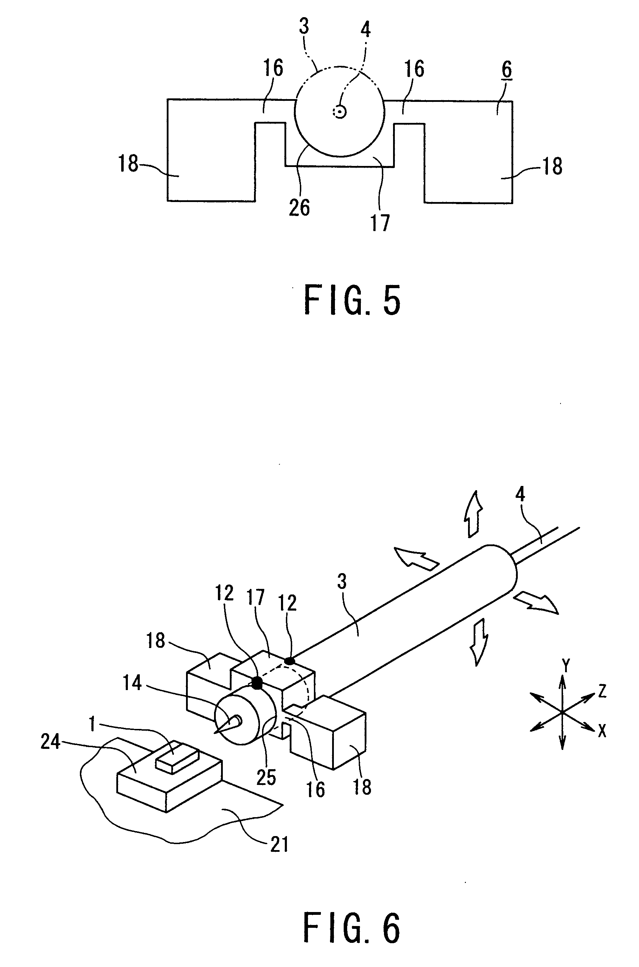

FIG. 6 is an explanatory drawing showing an embodiment of an optical coupling method of a semiconductor laser module. Firstly, the ferrule 3 is inserted and fitted into the supporting-member fitting portion 17 of the first fixing member 6, and the thus assembled ferrule and fixing member are arranged near a light emitting portion of the semiconductor laser 1.

Then, the semiconductor laser 1 and optical fiber 4 are aligned, in a state where the ferrule 3 is inserted and fitted by the supporting-member fitting portion 17 of the first fixing member 6. More specifically, the ferrule 3 is aligned in the three directions of X, Y, Z, while optically coupling the center core of the optical fiber 4 to the center of the laser light of the semiconductor laser 1. Then, at the thus obtained best optically coupled position, the fixing block portions 18 are fixed to the fixing-member mounting member 5 by laser welding. More specifically, there are formed the YAG-welding portions 13 as shown in FIG. 2.

In the state where the fixing block portions 18 are thus fixed to the fixing-member mounting member 5, the ferrule 3 is again aligned in the Z direction and Y direction. At the thus obtained best optically coupled position, the ferrule 3 is fixed to the supporting-member fitting portion 17 of the first fixing member 6 by laser welding. More specifically, there are formed YAG-welding portions 12 shown in FIG. 2.

Thereafter, the rearward portion of the ferrule 3 is moved in the X, Y directions about the bridge portions 16 to thereby conduct alignment, in a state where the fixing block portions 18 are fixed to the fixing-member mounting member 5 and the ferrule 3 is fixed to the supporting-member fitting portion 17. At the thus obtained best optically coupled position, the second fixing member 7 is arranged at the rearward portion of the ferrule 3, and the second fixing member 7 is fixed to the fixing-member mounting member 5 of the base by laser welding. More specifically, there are formed the YAG-welding portions 10 shown in FIG. 2.

Then, the rearward portion of the ferrule 3 is moved in the Y direction to thereby again conduct alignment, in a state where the fixing block portions 18 are fixed to the fixing-member mounting member 5, the ferrule 3 is fixed to the supporting-member fitting portion 17 and the second fixing member 7 is fixed to the fixing-member mounting member 5. At the thus obtained best optically coupled position, the rearward portion of the ferrule 3 is fixed to the second fixing member 7 by laser welding. More specifically, there are formed the YAG-welding portions 11 shown in FIG. 2.

The optical coupling may be performed after moving in advance the lens portions to the vicinity of the most appropriate optical coupling location obtained by an optical design of the semiconductor laser module. Furthermore, the optical coupling may be performed by sampling in practice some of the semiconductor module in each manufacturing lot, or in each member lot to obtain the most appropriate mean location, and moving remaining members which are not extracted to the vicinity of the above-mentioned most appropriate mean location in advance.

In this embodiment having been constituted in the above manner, the first fixing member 6, which supports the ferrule 3 by the portion closest to the semiconductor laser 1, is formed to include the supporting-member fitting portion 17 for fittedly receiving the ferrule 3, the fixing block portions 18 arranged at the opposite sides of the supporting-member fitting portion 17, and the bridge portions 16 for mutually coupling the fixing block portions 18 and supporting-member fitting portion 17. Thus, it becomes possible to tilt the ferrule 3 about the bridge portions 16 acting as a fulcrum, to thereby optically couple the center of the laser light of the semiconductor laser 1 and the center core of the optical fiber 4. Herein, the bridge portions 16 acting as the fulcrum are sculptured out of metal, so that these bridge portions 16 have superior durability against torsion than the YAG-welding portions.

Thus, differently from the conventional situation where there is conducted the optical coupling between the center of the laser light of the semiconductor laser 101 and the center core of the optical fiber 104 by tilting the ferrule 103 about the fulcrum consisting of the supporting/fixing portions 129 which are the welding portions between the ferrule 103 and first clamping/fixing member 106, there is prevented, in the semiconductor laser module of this embodiment, cracks of the welding portions due to stresses applied to the welding portions such as upon forming the semiconductor laser module or during usage of the semiconductor laser module, to thereby obtain a semiconductor laser module having an excellent optical coupling efficiency between the semiconductor laser 1 and optical fiber 4 and having an improved long-term reliability.

Further, according to the embodiment of the present invention, the bridge portions 16 of the first fixing member 6 may be formed at the same height as the center of the laser light of the semiconductor laser 1 and the center core of the optical fiber 4, and that end surface of each bridge portion 16 which is near to the semiconductor laser 1 may be flush with that end surface of the supporting-member fitting portion 17 which is near to the semiconductor laser 1. This allows to extremely precisely conduct the optical coupling by virtue of the principle of leverage about the aforementioned fulcrum, thereby allowing to extremely improve the optical coupling efficiency between the center of the laser light of the semiconductor laser 1 and the center core of the optical fiber 4 and to obtain an extremely improved long-term reliability thereof.

Further, according to this embodiment of the present invention, the YAG-welding portions 13, 11 and supporting/fixing portions 10 are formed at heights substantially in agreement with the center of the laser light of the semiconductor laser 1 and the center core of the optical fiber 4. Thus, even upon occurrence of flexure in the base 2, it is possible to substantially restrict the affection of the flexure, to thereby further improve the optical coupling efficiency between the center of the laser light of the semiconductor laser 1 and the center core of the optical fiber 4 as well as the long-term reliability thereof.

The present invention is not limited to the aforementioned embodiments, and can be applied to various configurations. FIG. 5 is a front drawing of a fixing member according to another embodiment of the present invention. For example, the supporting-member fitting portion 17 of the first fixing member 6 has the cylindrical hole portion 25 for fittedly and insertedly receiving the ferrule 3, in the aforementioned embodiments. However, such as shown in FIG. 5, the supporting-member fitting portion 17 may be a substantially U-shaped member having a groove portion 19 for fittedly receiving the ferrule 3.

According to the semiconductor laser module of the present invention, the first fixing member located at the position closest to the semiconductor laser so as to support the optical-fiber supporting member, is formed by coupling the supporting-member fitting portion for fittedly and insertedly receiving the optical-fiber supporting member to the fixing block portions arranged at the opposite sides of the supporting-member fitting portion through bridge portions. This allows to tilt the optical-fiber supporting member by virtue of the principle of leverage about the bridge portions acting as the fulcrum, to thereby optically couple the semiconductor laser and the optical fiber.

Thus, differently from the conventional situation where there is conducted optical coupling between the center of the laser light of the semiconductor laser and the center core of the optical fiber by angularly swinging the optical-fiber supporting member about the fulcrum consisting of the welding portions between the optical-fiber supporting member and first clamping/fixing member, there is prevented, in the semiconductor laser module of the present invention, cracks of the welding portions due to stresses applied to the welding portions such as upon forming the semiconductor laser module or during usage of the semiconductor laser module, to thereby obtain a semiconductor laser module having an excellent optical coupling efficiency between the semiconductor laser and optical fiber and having an improved long-term reliability.

Further, according to the constitution of the semiconductor laser module of the present invention where the bridge portions of the first fixing member are formed at the same height as the center of the laser light of the semiconductor laser, it becomes possible to extremely precisely conduct the optical coupling by virtue of the principle of leverage about the aforementioned fulcrum, thereby allowing to extremely improve the optical coupling efficiency between the semiconductor laser and optical fiber and to obtain an extremely improved long-term reliability thereof.

Moreover, according to the aligning method of a semiconductor laser module of the present invention, it becomes possible to optically couple the center core of the optical fiber with the center of the laser light of the semiconductor laser so as to attain an excellent optical coupling efficiency therebetween, to thereby obtain the semiconductor laser module capable of realizing the aforementioned excellent effects.

## Claims

1. A semiconductor laser module, comprising:
- a semiconductor laser (1) for emitting light;
- an optical fiber (4) having a tip end portion opposing to the semiconductor laser (1), which tip end portion is formed into a lens-shaped configuration (14) so as to optically couple with the semiconductor laser (1);
- an optical-fiber supporting member (3) for supporting the optical fiber (4); and
- at least one fixing member (6, 7) for supporting the optical-fiber supporting member (3), including:
- a supporting-member fitting portion (17) having a groove portion or a hole portion (25) into which the optical-fiber supporting member (3) is inserted or placed so as to be fitted therein;
- fixing block portions (18) positioned at both sides of the supporting-member fitting portion (17), respectively, so as to interpose the supporting-member fitting portion (17) between the fixing block portions (18) via gaps in a direction intersecting the longitudinal direction of the optical fiber (4); and
- bridge portions (16) for coupling the fixing block portions (18) to the supporting-member fitting portion (17), respectively.

2. A semiconductor laser module, comprising:
- a semiconductor laser (1) for emitting light;
- an optical fiber (4) having a tip end portion opposing to the semiconductor laser (1), which tip end portion is formed into a lens-shaped configuration (14) so as to optically couple with the semiconductor laser (1);
- an optical fiber supporting member (3) for supporting the optical fiber (4); and
- a group of fixing members (6, 7) comprising:
(i) a first fixing member (6) for supporting the optical-fiber supporting member (3), including: a supporting-member fitting portion (17) having a groove portion or a hole portion (25) into which the optical-fiber supporting member (3) is inserted or placed so as to be fitted therein; fixing block portions (18) positioned at both sides of the supporting-member fitting portion (17), respectively, so as to interpose the supporting-member fitting portion (17) between the fixing block portions (18) via gaps in a direction intersecting the longitudinal direction of the optical fiber (4); and bridge portions (16) for coupling the fixing block portions (18) to the supporting-member fitting portion (17), respectively; and
(ii) at least one additional fixing member (7) for supporting the optical-fiber supporting member (3) arranged at a distance from the first fixing member (6) along the longitudinal direction of the optical fiber (4).

3. The module according to claim 2,
wherein the group of fixing members (6, 7) comprises the first fixing member (6) and a second fixing member (7).

4. The module according to any of claims 1 to 3,
wherein the supporting-member fitting portion (17) has a hole portion (25) into which the optical-fiber supporting member (3) is inserted so as to be fitted therein.

5. The module according to any of claims 1 to 4,
wherein the fixing block portions (18), the supporting-member fitting portion (17) and the bridge portions (16) for connecting them are integrally formed as a single member (6), the bridge portions (16) being adapted to share a torsional stress applied thereto.

6. The module according to any of claims 2 to 5,
wherein each of the fixing block portions (18) is extended to a periphery of the second fixing member (7).

7. The module according to any of claims 1 to 5,
wherein each bridge portion (16) is arranged at substantially the same height as the center of a laser light of the semiconductor laser (1).

8. The module according to any of claims 1 to 7,
further comprising a base (2) including a semiconductor-laser mounting member (8) and a fixing-member mounting member (5) provided on the semiconductor-laser mounting member (8).

9. The module according to claim 8,
wherein the semiconductor-laser mounting member (8) and the base (2) are integrally formed as a single member.

10. The module according to claim 8 or 9,
wherein the fixing-member mounting member (5) has recessed portions corresponding to the fixing block portions (18), respectively, so as to fix the fixing block portions (18) by the recessed portions.

11. The module according to any of claims 1 to 10,
wherein joining portions of the fixing members (6, 7) are in the same plane.

12. The module according to any of claims 8 to 11,
wherein the fixing-member mounting member (5) of the base (2) has an upper surface (45) arranged at substantially the same height as the center of a laser light of the semiconductor laser (1).

13. The module according to any of claims 2 to 12,
wherein the first fixing member (6) is formed of a material having substantially the same thermal expansion coefficient as the optical-fiber supporting member (3).

14. The module according to any of claims 2 to 13,
wherein the first fixing member (6) is formed of an Fe-Ni alloy, an Fe-Ni-Co alloy or a metal such as nickel having a smaller Young's modulus.

15. The module according to any of claims 11 to 14,
wherein the joining portions comprise laser-welded portions (10 to 13).

16. An optical axis aligning method for a semiconductor laser module, comprising the following steps:
- preparing the first fixing member (6), the second fixing member (7), the semiconductor laser (1), the optical fiber (4), the optical-fiber supporting member (3) and the base (2) as recited in any of claims 1 to 15;
- performing a first step of an optical coupling between the center of a laser light of the semiconductor laser (1) and the center core of the optical fiber (4) in a state where the optical-fiber supporting member (3) is inserted and fitted by the supporting-member fitting portions (17) of the first fixing member (6), to fix the fixing block portion (18) of the fixing member (6) to the base (2);
- performing a second step of an optical coupling between the center of the laser light of the semiconductor laser (1) and the center core of the optical fiber (4) in a state where the fixing block portion (18) is fixed to the base (2), to fix the optical-fiber supporting member (3) to the supporting-member fitting portion (17) of the first fixing member (6);
- performing a third step of an optical coupling by means of moving a far end side of the optical-fiber supporting member (3) from the semiconductor laser (1) about a fulcrum consisting of the bridge portions (16) of the first fixing member (6) in a state where the optical-fiber supporting member (3) is fixed to the supporting-member fitting portion (17), to fix the second fixing member (7) to the base (2); and
- performing a fourth step of an optical coupling between the center of the laser light of the semiconductor laser (1) and the center core of the optical fiber (4) by means of further moving the far end side of the optical-fiber supporting member (3) from the semiconductor laser (1), to fix the optical-fiber supporting member (3) to the second fixing member (7).

17. The method according to claim 16,
wherein performing the optical coupling comprises an alignment of the optical-fiber supporting member (3) in three directions of the X-axis direction (width direction of the semiconductor laser module), the Y-axis direction (vertical direction), and the Z-axis direction (longitudinal direction of the semiconductor laser module) in the first step of the optical coupling; performing the optical coupling comprises aligning of the optical-fiber supporting member (3) in the Z-axis direction and the Y-axis direction in the second step of the optical coupling;
performing the optical coupling comprises aligning of the optical-fiber supporting member (3) in the X-axis direction in the third step of the optical coupling; and performing the optical coupling comprises aligning of the optical-fiber supporting member (3) in the Y-axis direction in the fourth step of the optical coupling.
